# EUROPÄISCHE PATENTSCHRIFT

(11) **EP 0 644 995 B1**
(45) Veröffentlichungstag und Bekanntmachung des Hinweises auf die Patenterteilung: **29.10.1997**
(21) Anmeldenummer: 93905249.4
(22) Anmeldetag: 16.02.1993
(51) Int. Cl.: F24J 2/54, F24J 2/08, H01L 31/052

(54) **PLATTFORM ZUR NUTZUNG DER SONNENENERGIE**
PLATFORM FOR RECOVERING SOLAR ENERGY
PLATE-FORME POUR L'EXPLOITATION DE L'ENERGIE SOLAIRE

(30) Priorität: 15.06.1992 US 898160
(43) Veröffentlichungstag der Anmeldung: 29.03.1995
(73) Patentinhaber: LAING, Johannes Nikolaus, D-71686 Remseck (DE)
(72) Erfinder: LAING, Johannes Nikolaus, D-71686 Remseck (DE); LAING, Inge, La Jolla, CA 92037 (US)
(74) Vertreter: Rosenich, Paul, Dipl.-Ing.
(86) Internationale Anmeldenummer: EP9300368
(87) Internationale Veröffentlichungsnummer: WO9325856

(56) Entgegenhaltungen:
- EP-A- 0 051 932
- WO-A-90/04142
- WO-A-91/17573
- DE-A- 3 934 516
- DE-A- 4 006 516
- US-A- 3 915 148
- US-A- 4 329 021
- PATENT ABSTRACTS OF JAPAN vol. 7, no. 132 (E-180)(1277) 9. Juni 1983 & JP-A-58 048 477 (NIPPON DENKI KK) 22. März 1983

## Beschreibung

### Technisches Gebiet

Die Erfindung beschreibt einen Aufbau einer Kollektorplattform für um eine Hochachse verschwenkbare Solarkraftwerke mit Photozellen nach dem Oberbegriff des Anspruchs 1. Die Kollektorplattform wird von einer Flüssigkeitsschicht getragen, eine tägliche Schwenkung um die Hochachse mit der Winkelgeschwindigkeit der Sonne erfährt und während der Nachtstunden wieder zurückgeschwenkt wird. Zur Nachführung der Sonnenhöhe wird die Einstrahlung in solchem Masse zur Vertikalen hin gebrochen, dass alle gebrochenen Sonnenstrahlen auf die Photozellen treffen.

### Stand der Technik

Solche Plattformen bzw. Solarkraftwerke sind bekannt. Insbesondere die WO 91/17573 der Anmelder beschreibt solche Aufbauten.

### Darstellung der Erfindung

Aufgabe der Erfindung ist eine Verbesserung des Wirkungsgrades solcher Anlagen, indem der Wirkungsgrad der Photozellen erhöht werden soll.

Zur Verwirklichung sieht die Erfindung gemäß Anspruch 1 eine Plattform vor, die Tröge aufweist, deren Boden im Betriebszustand unterhalb der Oberfläche der Flüssigkeitsschicht liegt, wobei die Photozellen in Wärmeleitverbindung mit den Trögen stehen, so dass die Verlustwärme durch den Boden hindurch in in die Flüssigkeit eingeleitet wird. Derart gekühlte Photozellen haben einen besseren Wirkungsgrad.

Die Lenkung der Sonnenstrahlen über ein möglichst grosses Sonnenelevationsintervall erfolgt durch ein Zylinderlinsensystem, welches vorzugsweise aus mehreren untereinander angeordneten Linsenanordnungn besteht. Die Erfindung bevorzugt ein System, bei dem zwischen den Linsenanordnungen dreieckige prismatische Kanäle gebildet werden, deren nicht durchstrahlte Grenzflächen verspiegelt sind. Diese eine mechanische Nachführung der Sonnenelevation substituierenden Linsenanordnungen, nachstehend Nachführlinsen genannt, sind oberhalb einer konzentrierenden Linse angeordnet. Eine vorteilhafte Ausführungsform sieht die Integration einer Nachführlinse mit einer Fresnellinse vor. Die Erfindung bezieht sich weiterhin auf Einrichtungen, die der möglichst gleichmässigen Bestrahlung der Photozellen dienen. Eine erste Massnahme besteht darin, dass die Photozellen in Trögen schwimmend der Höhenwanderung einer Brennlinie folgen. Eine vorteilhaftere Lösung sieht vor, dass Sekundärlinsen zur Kompensation der Höhenverschiebung eingesetzt werden. Dabei erweist es sich als vorteilhaft, wenn die Strahlung so gelenkt wird, dass die nach aussen weisende Schicht der horizontal ausgerichteten Linsenanordnung eine nach oben weisende erste, glatte Grenzfläche aufweist und auf der nach unten weisenden Seite eine Gruppe von in Stufen unterteilte zweite Grenzflächen besitzt, wobei die Grenzflächen der Stufen in einem solchen Winkel zur ersten Grenzfläche verlaufen, dass gegebenenfalls im Zusammenwirken mit weiteren Linsenanordnungen ein Sonnenstrahl, der mit der Vertikalen einen Winkel von mehr als 60° bildet, zu einem Austrittsstrahl gebrochen wird, der mit der Auftreffrichtung des Sonnenstrahles einen Winkel von mehr als 110° bildet und gleichzeitig mit der Vertikalen einen Winkel mit einem von der Auftreffrichtung abgewandten Schenkel einschliesst, der kleiner ist als 30°, während ein Sonnenstrahl, dessen Auftreffwinkel mit der Vertikalen einen Winkel von weniger als 20° bildet, zu einem in Richtung zur Sonne weisenden Austrittsstrahl gebrochen wird, dessen Schenkel in Richtung zur Sonne weist und der mit der Vertikalen einen Winkel von weniger als 30° bildet, so dass die Austrittsstrahien auf einen Strahlungswandler konzentriert werden. In der vorteilhaftesten Lösung sind die Austrittswinkel dem Betrage nach gleich.

### Kurze Beschreibung der Erfindung

Figur 1 zeigt schematisiert eine Plattform mit einer Randzone.

Figur 2 zeigt einen Ausschnitt II aus Figur 1 im Vertikalschnitt. Figur 3 zeigt eine perspektivische Darstellung einer Linsenanordnung.

Figur 4 zeigt den Strahlenverlauf in einer verfeinerten Version.

Figur 5a und 5b zeigen ein Flachlinsensystem mit Facetten.

Figur 6 zeigt eine Flachlinse mit Primär- und Sekundärstufen.

Figur 7 zeigt schematisiert die Bahnen gekrümmt verlaufender Stufen.

Figur 8a zeigt den Strahlenverlauf in einer vertikal und rechtwinklig zur Sonnenrichtung geschnittenen Sekundärlinse.

Figur 8b zeigt den Strahlenverlauf in der gleichen Sekundärlinse bei lateraler Auswanderung eines senkrechten Strahlenbüschels.

Figur 8c zeigt den Strahlenverlauf in der gleichen Sekundärlinse bei lateraler Auswanderung eines schräg verlaufenden Strahlenbüschels.

Figur 9 zeigt eine Ausführungsform, deren Querschnitt aus übereinanderliegenden Trapezoiden zusammengesetzt ist.

Figur 10 zeigt eine Sekundärlinse, die aus einer in den Aussenbereichen konvergierenden und im Innenbereich divergierenden Linse besteht, die durch spiegelnde Wandungen getragen wird.

Figur 11 zeigt schematisiert einen Querschnitt durch Rinnen, in denen Photozellen schwimmen.

Figur 12 zeigt eine Sekundärlinse zur Kompensation von lateraler Strahlenbüschel-Auswanderung durch Verschiebung eines Bauelementes.

Figur 13a, b, c zeigt die Gegenüberstellung der Umlenkungen bei unterschiedlicher Sonnenhöhe.

### Wege zur Ausführung der Erfindung

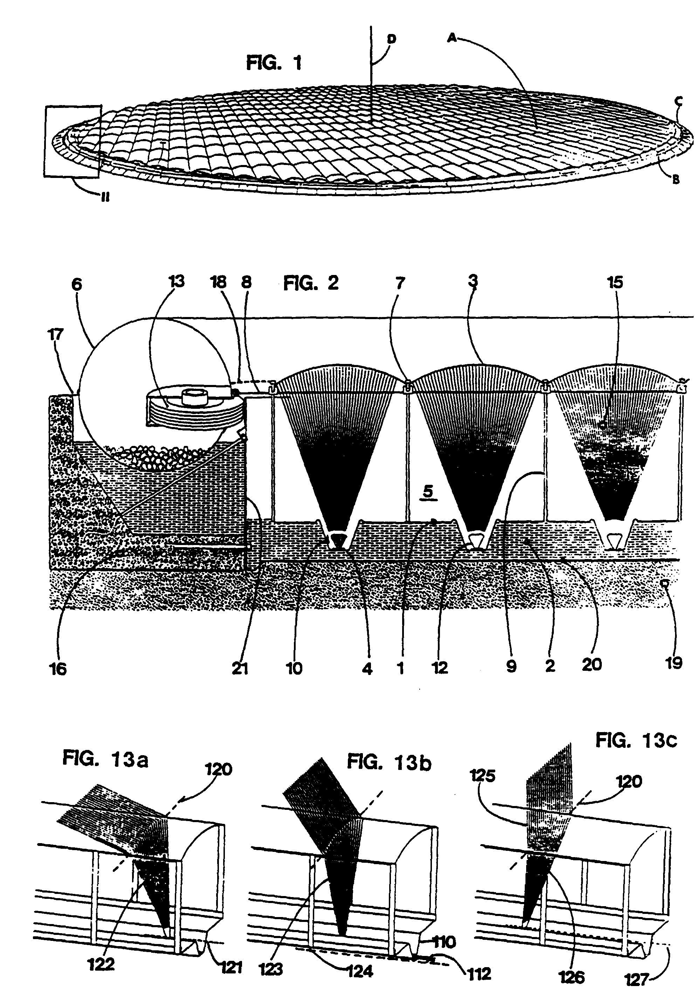

Figur 1 zeigt schematisiert das erfindungsgemässe Solarkraftwerk mit einer um die Hochachse d schwenkbaren Plattform a und einem Rahmen b, der in einer Rinne c schwimmt.

Figur 2 zeigt einen Horizontalschnitt des Ausschnittes II in Figur 1. Die Energiewandlung erfolgt auf einer kreisförmigen Plattform a, die von einer dünnen Wasserschicht 2 getragen wird. Sie ist in parallel zueinander verlaufende Konzentrator-Tunnel 5 unterteilt. Ein die Plattform umgebendes Torusrohr 6 bildet den Rahmen für ein Netz, welches die Konzentratortunnel auf exakter Distanz zueinander hält und die dem Torusrohr 6 aufgeprägte Drehbewegung auf die Plattform überträgt. Das Netz wird aus Blechprofil-Strängen 7 und Stahlseilen 8 gebildet und über dünnwandige Flachrohre 9 auf konstantem Abstand von Bodenblechen 1 aus Metall gehalten. Längs der Mittellinie jedes Konzentrator-Tunnels 5 verläuft eine Rinne 10, in der die Photozellen 4 liegen. Die Abdeckung bestent aus Konzentrator-Scheiben 3, die die Sonnenstrahlen nicht nur wie eine zylindrische Fresnellinse auf Brennstreifen konzentrieren sondern gleichzeitig die entstehenden Strahlenbüschel nach unten hin brechen. Die Photozellen 4 liegen zwischen strangförmigen Sekundärlinsen 12 und der Sohle der Profilrinne 10. Die Plattform wird durch das Torusrohr 6, welches durch Rollen 13, die an der ringförmigen Wand 21 abrollen, zentriert und mit der Winkelgeschwindigkeit der Sonne um die Hochachse d verschwenkt, so dass die Photozellen tagsüber mit bekannten Mitteln gesteuert stets dem Azimut der Sonne folgen. Während der Nacht wird die Plattform in die Ausgangsposition zurückgeschwenkt. Die Sekundärlinse 12 leitet die Strahlenbüschel unabhängig vom Niveau der jeweiligen Brennlinie auf die Photozelle 4, die die Unterseite der Sekundärlinse abdeckt. Im Konzentrator-tunnel 5 ist ein vertikal auftreffendes Strahlenbüschel 15 gezeigt. Der Spalt zwischen dem Torusrohr 6 und der Mauer 16 ist durch eine schleifende Folie 17 überbrückt. Ausserdem ist eine Folie 18 zwischen dem Torusrohr 6 und dem angrenzenden Energietunnel eingespannt, so dass eine Verdunstung von Wasser ausgeschlossen ist. Die Verlustwärme der Photozellen 4 wird, soweit sie nicht bereits während der Sonnenscheinstunden abgegeben wird, in die Wasserschicht 2 geleitet, die durch eine Folie 20 vom Erdreich 19 getrennt ist. Die vom Wasser gespeicherte Wärme wird 24 Stunden täglich über Konvektion und Infrarot-Strahlung ausgeleitet. Die von der Plattform erzeugte Elektrizität wird über flexible Leiter in ein zum Zentrum führendes Erdkabel geleitet. Regenwasser gelangt durch die Flachrohre 9 in die Wasserschicht 2, aus der überflüssiges Wasser abfliessen kann.

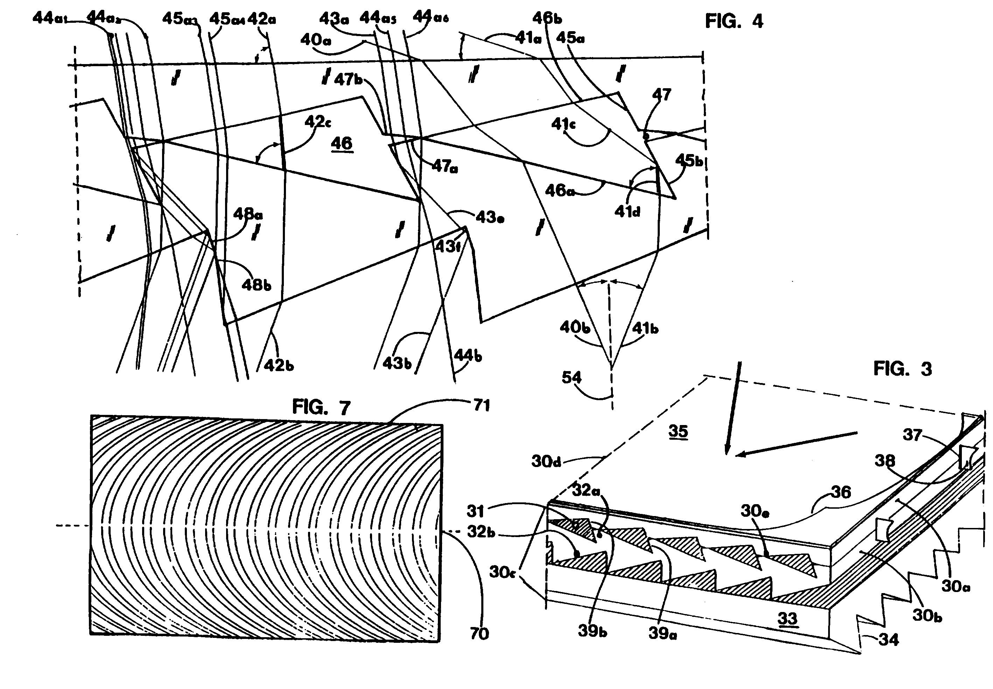

Figur 3 zeigt in perspektivischer Darstellung eine Linsenanordnung, die aus einer oberen Schicht 30a mit Stufen 30e und einer darunterliegenden Schicht 30b mit Stufen 32a und 32b besteht, die Kanäle 31 zwischen sich einschliessen. Unter dieser Stufenlinse 30a, 30b verläuft eine Fresnellinse 33, deren Stufen 34 rechtwinklig zu den Stufen 32 verlaufen. Die Schichten 30a und 30b weisen vertikale Rillen 37 auf, in die Blechstreifen 38 eingelegt werden, so dass sich die Schichten nicht zueinander bewegen können. Die Flanken 39a und 39b sind vorzugsweise verspiegelt. Für Gegenden mit Sandstürmen sind auf der Aussenseite der Linsenanordnung mehrere Lagen 35 einer extrem dünnen Folie befestigt. Ist die Oberfläche der jeweils obersten Schicht 36 verkratzt, so wird diese abgezogen. Es hat sich als vorteilhaft erwiesen, dass die Kante 30c nach unten hin abgebogen ist, so dass die Linie 30d gekrümmt verläuft, wodurch gewölbte Dachelemente gemäss Figur 2 entstehen. Dies gilt sinngemäss für alle Flachlinsenvarianten.

Figur 4 zeigt einen Querschnitt durch eine Linsenanordnung 30 mit den Strahlen der Sonne bei 20° und 80° Elevation. Während die Strahlen 40a nach vierfachem Durchtritt durch Grenzflächen als Strahl 40b austreten, wobei sie mit der Vertikalen 54 einen Winkel von 18° einschliessen, muss der Strahl 41a an der Flanke 45b reflektiert werden. Aus diesem Grunde sind die Flanken 45a und 45b verspiegelt. Der Strahl 42a durchsetzt nach zweimaligem Durchtritt durch Grenzflächen als Strahl 42c den Kanal 46 und tritt als Strahl 42b mit dem gleichen Winkel zur Vertikalen aus wie der Strahl 40b, jedoch mit entgegengesetztem Vorzeichen. Der morgendliche flache Strahl 41a tritt nach zweimaliger Brechung als Strahl 41c in den Kanal 46 ein und wird dann zum Strahl 41d reflektiert. Dieser Strahl 41d verläuft parallel zum Strahl 42c, so dass auch der Austritt 41b mit dem Winkel +18° zur Senkrechten 54 wie Strahl 42b erfolgt. Alle zwischen den Grenzen der morgendlichen Einstrahlung von 20° und der mittäglichen Einstrahlung von 80° auftreffenden Sonnenstrahlen führen zu Austrittsstrahlen, die innerhalb des Austrittswinkelintervalles 40b - 41b liegen. Der Strahl 43a trifft nach dreifacher Brechung auf die Flanke 45b, erfährt dort eine Totalreflexion und wird zum Strahl 43e. Danach tritt er als Strahl 43f aus und wird am verspiegelten Flankenbereich 48a so reflektiert, dass er innerhalb des erlaubten Winkelintervalles als Strahl 43b austritt. Alle 80°-Strahlen zwischen den Strahlen 44a₁ und 44a₂ würden ausserhalb des erlaubten Winkelintervalles austreten, wenn die Flanken 45a und 45b ineinander übergehen würden. Damit diese Strahlen nicht verlorengehen, schliesst an den Kanal 46 mit den durchstrahlten Flächen 46a und 46b ein Kanal 47 mit den durchstrahlten Flächen 47a und 47b an, dessen durchstrahlte Wandungen die Strahlen 44a₁ bis 44a₂ gegebenenfalls in Verbindung mit einer Reflexion am oberen verspiegelten Streifen 48a der Flanke 48a, 48b so lenken, dass sie im erlaubten Intervall austreten. Die Strahlen zwischen den Strahlen 45a₃ und 45a₄ erfahren an der Flanke 48b eine Totalreflexion und treten dann innerhalb des erlaubten Winkelintervalles aus. Der Strahl 44a₅ tritt als Strahl 44b mit negativem Winkel aus, die dann folgenden Strahlen bis 44a₆ erfahren Totalreflexion an der Flanke 45b und treten wie auch der Strahl 43b mit positivem Winkel im erlaubten Winkelbereich aus. Alle rechts davon liegenden Strahlen durchsetzen die Zylinderlinse wie der Strahl 42a mit positivem Winkel.

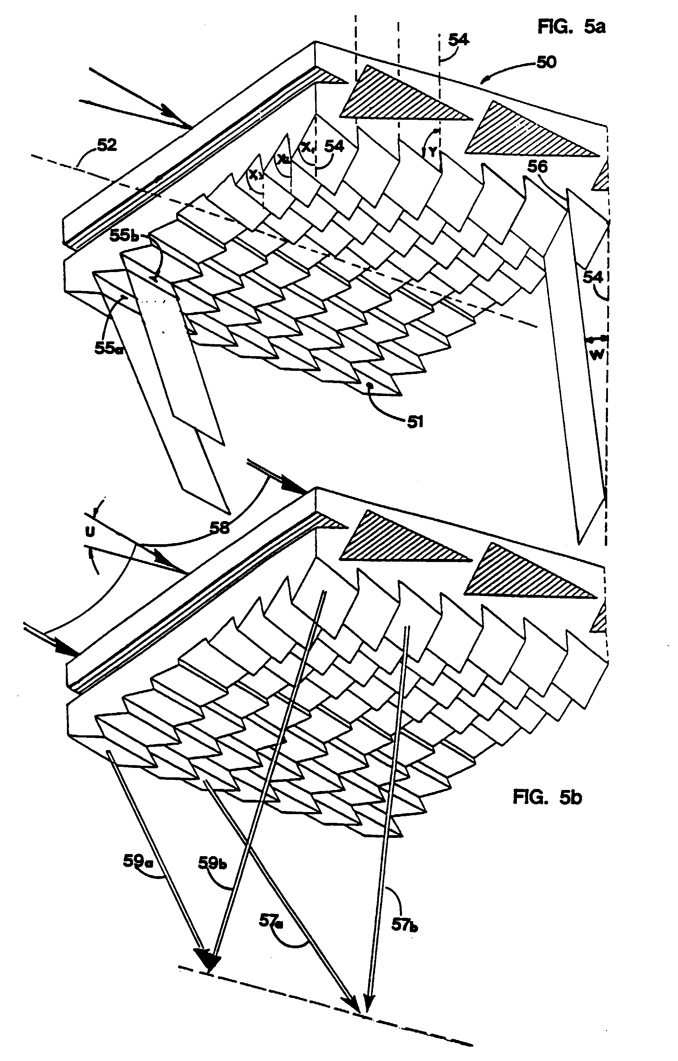

Figur 5a zeigt schematisiert eine Ausführungsform der Linsenanordnung gemäss Figur 3 und 4, bei der die nach unten weisenden Stufen 32 mit den rechteckig dazu verlaufenden Stufen 34 der darunterliegenden Fresnellinse zu Facettenlinsen zusammengefasst sind. Die plane nach oben weisende Oberseite 50 bildet die Eintrittsfläche. In den senkrecht zur Sonneneinstrahlung 53 verlaufenden Ebenen bilden die Rechteckbereiche 51 mit der Vertikalen 54 die Winkel x₁, x₂, x₃, ..., die im Bereich der Symmetrielinie 52 zu 90° werden. Die zur Photozelle weisenden Rechteckbereiche 51 sind jedoch gleichzeitig in Ebenen, in denen die Sonnenstrahlen 53 verlaufen, um den konstanten Winkel y zur Vertikalen 54 geneigt. Es entstehen dadurch Strahlenbüschel, die gleichzeitig zur Vertikalen 54 hin gebrochen sind. Die Ebenen der Flanken 55a, 55b usw. schneiden sich in der Nähe der Brennlinie, um Abschattung der austretenden Strahlung der jeweils folgenden Stufe zu verhindern. Die senkrecht zur Symmetrielinie 52 verlaufenden Flanken 56 liegen sämtlich in Ebenen, die mit der Vertikalen 54 den konstanten Winkel w gemäss Figur 4 einschliessen.

In Figur 5b bilden die Strahlen 57a und 57b die Randstrahlen des Strahlenbüschels, das beim Elevationswinkel u der Sonnenstrahlen 58 entsteht. Die Randstrahlen 59a und 59b, die einem Elevationswinkel von 60° zugeordnet sind, verlaufen auf einer Vertikalebene.

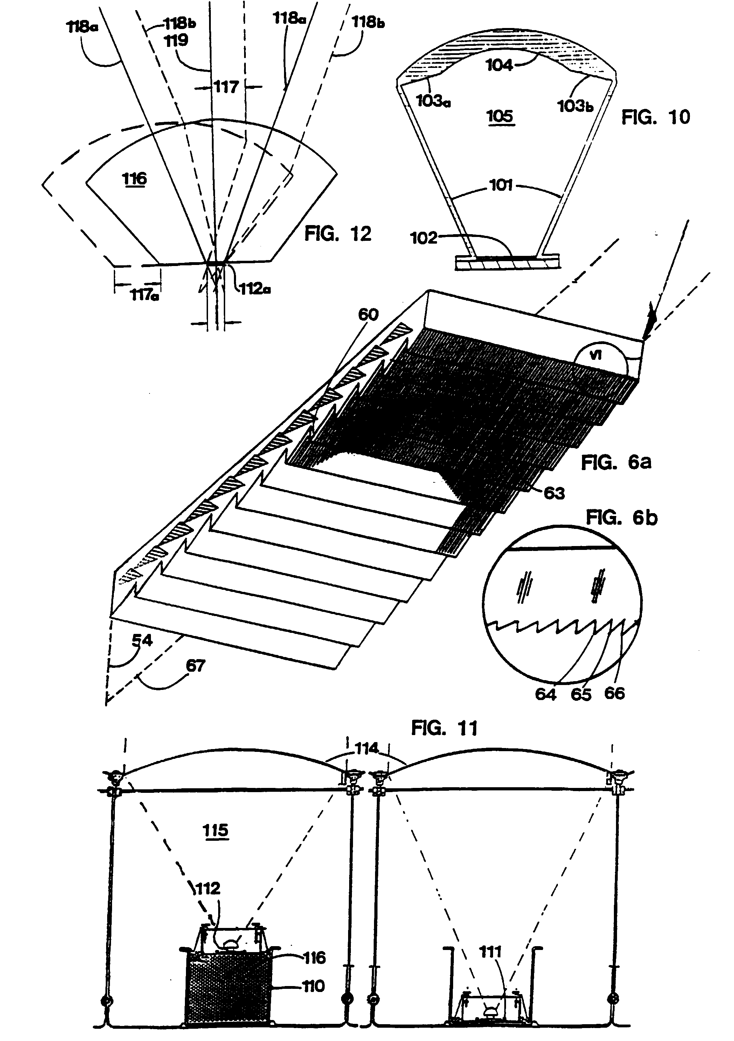

Figur 6a zeigt eine andere Ausführungsform einer erfindungsgemässen Linse, die senkrecht zur Einstrahlungsebene verlaufende Stufen 60 aufweist, so dass flach auftreffende Sonnenstrahlen 61 zur Vertikalen 54 hin gebrochen werden. Steil auftreffende Strahlen mit vertikaler Vorzugsrichtung werden zur Sonnenseite hin gebrochen. Die Oberflächen der Stufen 60 sind ihrerseits mit Stufen 63 von wesentlich feinerer Teilung gestuft.

Figur 6b zeigt die Stufen im eingerahmten Bereich VI in vergrösserter Darstellung. Die Stufen 64, 65, 66 weisen zur Symmetrielinie 67 weisende Prismenwinkel auf, die in Höhe der Symmetrielinie zu Null werden. Diese Stufen bewirken die Konzentration.

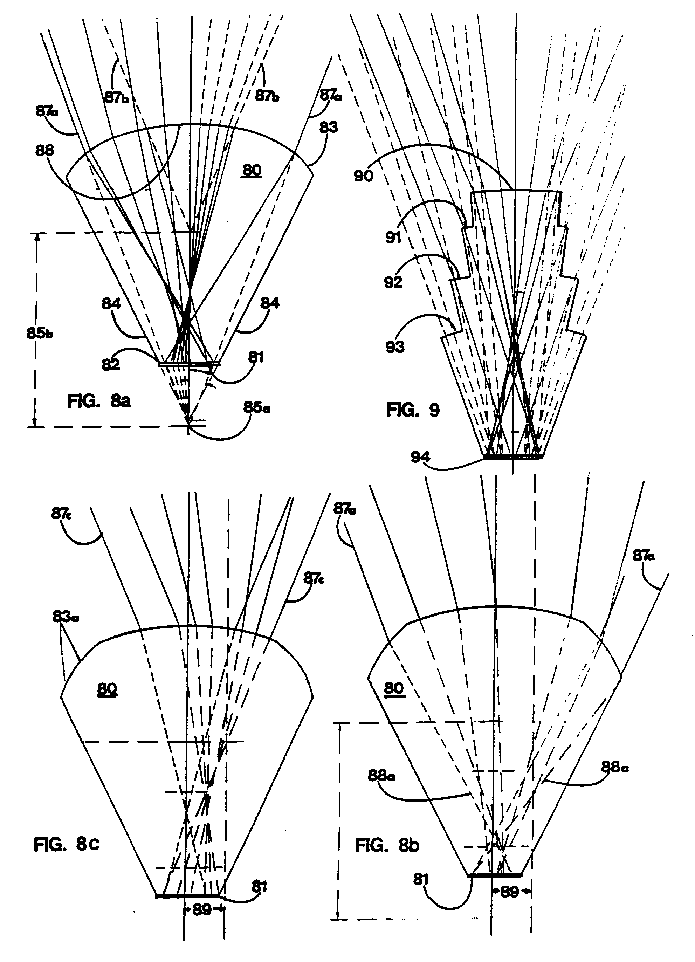

Figur 7 zeigt eine Flachlinse von unten betrachtet. Symmetrisch zur Scheitellinie 70 auf annähernd parabolischen Linien verlaufen Stufen 71, deren Prismenwinkel in Höhe der Scheitellinie 70 Nullwert annehmen und zu beiden Seiten mit zunehmendem Abstand von der Scheitellinie 70 anwachsen. Jedes in einem Abstand von der Scheitellinie 70 liegende Betrachtungselement der Stufen 71 weist einen Keilwinkel auf, der im Zusammenwirken mit dem Winkel, den die Tangente am Betrachtungselement mit der Scheitellinie 70 einschliesst, einen von der (nicht sichtbaren) Oberseite durchtretenden Sonnenstrahl im optischen Sinne windschief zu einer Brennlinie hin bricht.

Figur 8a zeigt den Querschnitt einer Zylinderlinse 80, die mit der Photozelle 81 in optischem Kontakt steht. Dieser Kontakt wird durch Einbringen einer benetzenden Immersionsflüssigkeit oder eines optischen Kitts 82 mit angepasster Brechzahl erreicht. Die Geometrie löst die Forderung, dass bei allen vorkommenden Strahlenbüscheln mit den Randstrahlen 87a und 87b die Solarzelle 81 mit annähernd gleicher Bestrahlungsstärke beleuchtet wird. Dies wird erreicht durch eine Zylinderlinse, deren Querschnittsform im unteren Teil trapezförmig ist und im oberen Teil einer asphärischen plankovexen Zylinderlinse entspricht. In einer bevorzugten Ausführungsform hat die Eintrittsfläche 83 eine elliptische Schnittkurve. Die Seitenflächen 84 sind ebenfalls als optische Funktionsflächen ausgeführt, damit im Bedarfsfall Totalreflexion stattfindet. Die Brennlinien 85a, die unterhalb der Photozelle 81 liegen würden, werden durch die Form der Eintrittsfläche oberhalb der Photozellen 81 abgebildet, so dass bei keiner Sonnenelevation die Brennlinie durch die Zelle hindurchwandert. Die Brennlinienwanderung würde ohne Sekundärlinse den Betrag 85b annehmen. Die Brennlinie wird durch die Sekundärlinse so verlegt, dass bei einer geeigneten Zuordnung der Photozelle 81 zur Eintrittsfläche 83 eine im wesentlichen gleichmässige Verteilung der Bestrahlungsstärke über die Zellenbreite erreicht wird, was einer unscharfen Abbildung der Brennlinien auf die Photozellen entspricht.

Für den Fall, dass beim Betreiben des Kraftwerkes eine Lateralverschiebung zwischen Folgelinse und Sekundärlinse infolge von Störkräften eintritt, bewirkt die Eintrittsfläche 83 eine optische Kompensation der Auswanderung der Brennlinie. Während bei senkrecht verlaufenden Strahlenbüscheln mit den Randstrahlen 87a die aussen liegenden Strahlen konvergierend gelenkt werden, erfahren die Strahlen eines schrägliegenden Strahlenbüschels mit den Randstrahlen 87b eine divergierende Brechung.

Figur 8b zeigt die gebrochenen Strahlen 88a des vertikal auftreffenden Strahlenbüschels mit den Randstrahlen 87a wobei die Sekundärlinse 80 lateral zum Strahlenbüschel um einen Betrag 89 verschoben ist.

Figur 8c zeigt den Strahlenverlauf für die in Figur 13a und 13c dargestellte Schräglage der Strahlenbüschel 122 und 126 mit den Randstrahlen 87c bei einer lateralen Auswanderung um den Betrag 89.

Eine weitere Gestaltung einer mit der Photozelle 94 verbundenen Sekundärlinse zeigt Figur 9, deren Wirkung der Sekundärlinse der Figur 8 entspricht. Aufgrund der geringeren Querschnittsfläche wird erheblich Material eingespart und durch die kürzeren Lichtwege für die Randstrahlen wird eine geringere Dämpfung erreicht. Die in Figur 8 beschriebene Gestaltung der Eintrittsfläche 83 wird auf die Flächen 90, 91, 92 und 93 aufgeteilt. Auch hier werden sämtliche Seitenflächen so gestaltet, dass eine Totalreflexion der unter Umständen von innen auftreffenden Strahlen gewährleistet wird.

Figur 10 zeigt eine Sekundärlinse, deren aussen liegende Bereiche 103a und 103b die äusseren Bereiche eines Strahlenbüschels, welches in einer Vertikalebene liegt, konvergierend bricht während sie diese Strahlen eines in einer schrägliegenden Ebene verlaufenden Strahlenbüschels durch den mittleren Bereich 104 divergierend bricht. Die Seitenwände 101 sind verspiegelt, wodurch auch horizontal ausgewanderte Strahlen auf die Photozelle 102 reflektiert werden. Sofern der Linsenbereich aus organischem Glas gefertigt ist, können die den darunterliegenden Raum 105 einschliessenden Wandungen 101 einstückig mit dem Linsenbereich gefertigt sein.

Figur 11 zeigt einen Querschnitt eines Konzentratortunnels 115 mit einer Rinne 110, in der ein Ponton 111 auf einem Wasserkörper 116 schwimmt, welches die Photozelle 112 aufnimmt. Die Höhe des Wasserkörpers 116 in der Rinne bestimmt den Abstand der Photozelle 112 von der Flachlinse 114.

Figur 12 zeigt eine Sekundärlinse 116, die relativ zur Photozelle 112a lateral um den Betrag 117a verschieblich angeordnet ist, die durch eine nicht gezeigte Vorrichtung in Abhängigkeit von der lateralen Auswanderung des Strahlenbüschels relativ zur Photozelle 112a die Verschiebung um den maximalen Betrag 117a bewirkt. Hierdurch wird das Strahlenbüschel mit den Randstrahlen 118a auch dann auf die Photozelle 112a gelenkt, wenn diese Randstrahlen bis zum Abstand 117 von der Symmetrielinie 119 in die Position 118b ausgewandert sind.

Figur 13a zeigt ein Strahlenbüschel, das durch die eingangs beschriebenen Flachlinsen erzeugt wird. Frühmorgens und Spätnachmittags erfolgt die stärkste Brechung um rechtwinklig zur Brennlinie 121 verlaufende Achsen 120. Das gebrochene Strahlenbüschel 122 bildet mit der Vertikalen einen Winkel von ca. -18°. Die Brennlinie 121 hat bei dieser Schräglage des Strahlenbüschels die grösste Höhe.

Figur 13b zeigt, dass das Strahlenbüschel 123 zweimal täglich, wenn die Sonnenhöhe jeweils ca. 60° beträgt, senkrecht verläuft. Die theoretische Brennlinie 124 liegt dann unterhalb der Photozelle 112, die die gesamte konzentrierte Strahlung auffängt. Sie liegt sogar unterhalb der Rinne 110 und erreicht damit den tiefsten Stand.

Wie Figur 13c zeigt, werden die 12-Uhr-Sonnenstrahlen 125 so um die rechtwinklig zur Brennlinie verlaufende Achse 120 in Richtung zur Sonne hin gebrochen, dass die Strahlenbüschel 126 auf Ebenen verlaufen, die mit der Vertikalen einen Winkel von +18° einschliessen. Die Brennlinie 127 erreicht dabei wieder die gleiche Höhe wie frühmorgens und spätnachmittags die Brennlinie 121.

## Patentansprüche

1. Aufbau einer Kollektorplattform für um eine Hochachse (D) verschwenkbare Solarkraftwerke, die auf einer Flüssigkeitsschicht (2) schwimmt, und ein im Abstand darüber verlaufendes transparentes Dach (3,114) aufweist, welches die auftreffenden Sonnenstrahlen nach unten bricht und auf darunter in parallel zueinander verlaufenden Trögen (10) angeordnete Photozellen (4) konzentriert, dadurch gekennzeichnet, dass die Photozellen (4) mit den Trögen (10) in Wärmeleitverbindung stehen, und dass die Tröge (10) so ausgebildet sind, dass die Verlustwärme der Photozellen (4) zum überwiegenden Teil durch einen unterhalb der Oberfläche der Flüssigkeitsschicht (2) liegenden Bereich der Tröge (10) hindurch in die Flüssigkeitsschicht (2) eingeleitet wird.

2. Aufbau nach Anspruch 1, dadurch gekennzeichnet, dass die nach aussen weisende Schicht des transparenten Daches (3) eine horizontal verlaufende Flachlinse (30a) mit einer ersten nach aussen weisenden glatten Grenzfläche (35, 50) bildet, die auf ihrer nach unten weisenden Seite eine Gruppe von in Stufen (30e) unterteilte zweite Grenzfläche aufweist, die in Betriebsstellung quer zu den Sonnenstrahlen verlaufen, wobei die Stufen (30e) einen solchen Winkel mit der ersten Grenzfläche (35, 50) einschliessen, dass gegebenenfalls im Zusammenwirken mit einer weiteren Flachlinse (30b) mit Stufen (32a) und gegebenenfalls mit rechtwinklig zu den genannten Stufen verlaufenden Stufen (34, 51, 64, 65, 66) ein Sonnenstrahl (40a) mit einem Zenitwinkel von mehr als 60° zu einem Austrittsstrahl (40b) gebrochen wird, der zur sonnenabgewandten Richtung mit der Vertikalen einen Winkel von weniger als 30° bildet, während ein Sonnenstrahl (42a) mit einem Zenitwinkel von weniger als 20° zu einem in Richtung zur Sonne weisenden Austrittsstrahl (42b) gebrochen wird, der mit der Vertikalen (54) einen Winkel von weniger als 30° bildet und dass die aus dem transparenten Dach (3) austretenden Strahlen auf eine parallel zu den Sonnenstrahlen verlaufende Brennlinie (121, 124, 127) konzentriert werden.

3. Aufbau nach Anspruch 2, dadurch gekennzeichnet, dass die ein Zenitwinkelintervall begrenzenden Strahlen (40a und 42a) zu ihren zugehörigen Austrittsstrahlen (40b und 42b), welche mit der Vertikalen (54) je einen Winkel von annähemd gleichem Betrag jedoch entgegengesetzten Vorzeichen einschliessen, gebrochen werden.

4. Aufbau nach Anspruch 2 oder 3, dadurch gekennzeichnet, dass die nach unten weisenden Stufen (30e) der nach aussen weisenden Flachlinse (30a) zusammen mit nach oben weisenden Stufen-(32a) gleicher Stufenteilung einer darunterliegenden Flachlinse (30b) prismatische Kanäle (31) einschliessen.

5. Aufbau nach Anspruch 4, dadurch gekennzeichnet, dass rechtwinklig zu den Kanälen (31) Rillen (37) verlaufen, in die dünnwandige, bandförmige Streifen (38) hineinragen, die die Flachlinsen (30a und 30b) zueinander in Richtung der Kanäle (31) fixieren.

6. Aufbau nach einem der Ansprüche 2 bis 4, dadurch gekennzeichnet, dass die durchstrahlten Grenzflächen der Stufen (z.B. 30e und 32a) der übereinanderliegenden Flachlinsen (30a und 30b) aus nebeneinanderliegenden, parallel zueinander verlaufenden streifenförmigen Bereichen (46a und 47a, 46b und 47b) bestehen, die einen stumpfen Winkel miteinander einschliessen.

7. Aufbau nach einem der Anspüche 2 bis 4, dadurch gekennzeichnet, dass die Flanken der nach unten weisenden Stufen der untenliegenden Flachlinse (30b) übereinanderliegende streifenförmige Bereiche (48a,48b) aufweisen, die miteinander stumpfe Winkel einschliessen.

8. Aufbau nach einem der Ansprüche 4 bis 7, dadurch gekennzeichnet, dass die durchstrahlten Grenzflächen (46b, 47b) jeder Stufe der oben liegenden Flachlinse (30a) und die durchstrahlten Grenzflächen (46a, 47a) jeder nach oben weisenden Stufe der darunterliegenden Flachlinse (30b) zwei dreieckige Kanäle (46,47) einschliessen, deren grösserer (46) sich in Betriebsstellung zur Sonne weisend verjüngt und deren kleinerer (47) sich in Betriebsstellung zur Sonne weisend erweitert.

9. Aufbau nach einem der Ansprüche 2 bis 8, dadurch gekennzeichnet, dass die nach unten weisende Seite des transparenten Daches aus Facetten (51) mit parallel und rechtwinklig zur.senkrechten Einstrahlungsebene verlaufende Kanten besteht, wobei die durchstrahlten Flächen der Facetten (51) so zur Horizontalen geneigt sind, dass ein Vertikalschnitt durch die Facetten (51) rechtwinklig zur vertikal verlaufenden Einstrahlungsebene einem Schnitt durch eine Fresnellinse gleicht, und dass ein Schnitt der Facetten parallel zur Einstrahlungsebene eine periodische Stufung zeigt.

10. Aufbau nach Anspruch 2 bis 4, dadurch gekennzeichnet, dass die flankenbildenden Flächen (45a, 45b, 48a, 48b) der dachbildenden Flachlinsen, die in Betriebsstellung nicht von in ein Austrittswinkelintervall (40b, 41b) gelangenden Strahlen durchsetzt werden, verspiegelt sind, und dass diese verspiegelten Flächen (45a, 45b, 48a, 48b) mit der Vertikalen (54) einen solchen Winkel einschliessen, dass auf diese Flanken auftreffende Strahlen (41c) in eine solche Richtung reflektiert werden, dass sie innerhalb des durch nur gebrochene Sonnenstrahlen (40b und 42b) gebildeten Austrittsintervalles austreten.

11. Aufbau nach einem der vorhergehenden Ansprüche 2 bis 10, dadurch gekennzeichnet, dass die erste Gruppe von nach unten weisenden Stufen (60) einer dachbildenden Flachlinse eine grobe Teilung aufweist, und dass die durchstrahlten Grenzflächen dieser Stufe (60) rechtwinklig zu den Stufen (60) verlaufende Sekundärstufen (64, 65, 66) tragen, die eine feinere Teilung mit den sich ändernden Winkeln einer Fresnellinse aufweisen.

12. Aufbau nach einem der vorhergehenden Ansprüche, dadurch gekennzeichnet, dass das transparente Dach (3) eine Flachlinse enthält, deren prismenbildende Stufen (71) symmetrisch zu einer parallel zur Einstrahlungsebene liegenden Scheitellinie (70) auf gekrümmten Bahnen verlaufen, wobei die Prismenwinkel über die Länge der Stufen mit zunehmendem Abstand von der Scheitellinie (70) grösser werden, femer dass die jedem Abstand von der Scheitellinie (70) zugeordneten Prismenwinkel und die Winkel zwischen den jeweiligen Tangenten an der Stufe (71) und der Scheitellinie (70) so gewählt sind, dass alle auftreffenden Sonnenstrahlen zu einer Brennlinie hin gebrochen werden.

13. Aufbau nach einem der vorhergehenden Ansprüche, dadurch gekennzeichnet, dass zwischen dem transparenten Dach (3) und den Photozellen (4, 81, 94) eine Sekundärlinse (12, 80, 103, 104) angeordnet ist, deren optische Geometrie Strahlenbüschel, die in Abhängigkeit vom jeweiligen Zenitwinkel Brennlinien (121, 124, 127) von unterschiedlichem Abstand vom transparenten Dach (3) erzeugen, innerhalb der Grenzen eines vorgegebenen Zenitwinkelintervalles auf die Photozellen (4, 81, 94) lenken.

14. Aufbau nach Anspruch 13, dadurch gekennzeichnet, dass die Photozellen (4, 81, 94, 112a) mit der Sekundärlinse (12, 80) optisch abstandslos verbunden sind.

15. Aufbau nach Anspruch 13 oder 14, dadurch gekennzeichnet, dass die Geometrie der Sekundärlinse (12, 80, 103, 104) die zu Strahlenbüscheln (122, 123, 126) gebrochenen Sonnenstrahlen, sofem diese zu den Photozellen (81, 94,102) lateral versetzt auf die Sekundärlinse (12, 80, 103, 104) auftreffen, so lenkt, dass diese Strahlenbüschel (122, 123, 126) innerhalb eines vorgegebenen Intervalles (89) der lateralen Auswanderung stets auf die Photozellen (81, 94, 102) auftreffen.

16. Aufbau nach einem der Ansprüche 13 bis 15, dadurch gekennzeichnet, dass die Form der Eintrittsfläche (83, 83a) der Sekundärlinse (80) so gestaltet ist, dass die Brennlinien innerhalb der Sekundärlinse (80) verlaufen, so dass sie bei kleinem Zenitwinkel durch die Photozellen (81) hindurchwandern.

17. Aufbau nach einem der Ansprüche 13 bis 16, dadurch gekennzeichnet, dass der Querschnitt der Sekundärlinse (80) ein Trapez bildet, dessen Unterseite den Photozellen (81, 94, 102) zugewandt ist und welches symmetrisch divergierende Seiten (84) und eine aus drei Bereichen gebildete Oberseite (83) aufweist, die aus Bereichen (83a), die Abschnitte einer längs geschnittenen oberen Hälfte einer Ellipse mit horizontal verlaufender langer Achse ähneln,und einem mittleren Bereich (88, 90, 104) besteht, der eine divergierende Brechung schräg auftreffender Strahlen (87b) bewirkt.

18. Aufbau nach Anspruch 13, dadurch gekennzeichnet, dass die Unterseite der Sekundärlinse (80) den Photozellen (81, 94, 102) zugewandt ist und dass der Querschnitt der Sekundärlinse symmetrisch zur Vertikalen verlaufende Wandbereiche aufweist, die aus Seiten übereinanderliegender Trapezoide gebildet sind und dass die Oberseite (90) einem Bogenabschnitt eines Kreises ähnelt.

19. Aufbau nach Anspruch 13, dadurch gekennzeichnet, dass eine Zylinderlinse (104), deren Aussenbereiche (103a, 103b) konvergierend brechen, durch verspiegelte Wandungsbereiche (101) in einem vorbestimmten Abstand oberhalb der Photozellen (102) gehalten wird.

20. Aufbau einer Kollektorplattform nach Anspruch 1, dadurch gekennzeichnet, dass der Abstand zwischen Photozellen und transparentem Dach einstellbar ist.

21. Aufbau nach einem der vorhergehenden Ansprüche, dadurch gekennzeichnet, dass ein Element einer Baugruppe, die aus einer Photozelle (112a) mit Mittellinie (119) und einer Sekundärlinse (116) oder einem Teil einer solchen Sekundärlinse besteht, relativ zu einem anderen solchen Element verschieblich angeordnet ist, wobei der Abstand (117a) zwischen der Mittellinie (119) und der Symmetrielinie der Sekundärlinse (116) veränderlich ist und dass Mittel in Abhängigkeit von der Auswanderung der Zone der höchsten Bestrahlungsstärke von der Photozelle (112a) eine relative Verschiebung bewirken, die die Photozelle (112a) und die Zone der höchsten Bestrahlungsstärke wieder zur Deckung bringen.

22. Aufbau nach einem der vorhergehenden Ansprüche, dadurch gekennzeichnet, dass auf dem transparenten Dach (3, 30, 50) mehrere Lagen (35) einer extrem dünnen abziehbaren Folie (36) angeordnet sind.

## Claims

1. Structure of a collector platform for solar power stations rotatable about a vertical axis (D), which floats on a liquid layer (2) and has a transparent roof (3, 114) which runs a distance above this and which refracts the incident sun rays downwards and concentrates them on photocells (4) arranged underneath in troughs (10) parallel to one another, characterized in that the photocells (4) have a thermally conducting connection with the troughs (10), and that the troughs (10) are formed in such a way that the dissipated heat of the photocells (4) is for the predominant part passed into the liquid layer (2) through a region of the troughs (10) which lies below the surface of the liquid layer (2).

2. Structure according to Claim 1, characterized in that the outward-pointing layer of the transparent roof (3) forms a horizontal flat lens (30a) which has a first outward-pointing smooth boundary surface (35, 50) and possesses, on its downward-pointing side, a group of second boundary surfaces which are divided into steps (30e) and, in the operating position, are transverse to the sun rays, the steps (30e) making an angle with the first boundary surface (35, 50) such that, optionally in cooperation with a further flat lens (30b) having steps (32a) and optionally steps (34, 51, 64, 65, 66) at right angles to the stated steps, a sun ray (40a) having a zenith angle of more than 60° is refracted to give an emerging ray (40b) which makes an angle of less than 30° with the vertical in a direction facing away from the sun, while a sun ray (42a) having a zenith angle of less than 20° is refracted to give an emerging ray (42b) which is directed towards the sun and makes an angle less than 30° with the vertical (54), and that the rays emerging from the transparent roof (3) are concentrated onto a focal line (121, 124, 127) parallel to the sun rays.

3. Structure according to Claim 2, characterized in that the rays (40a and 42a) bounding a zenith angle interval are refracted to give their associated emerging rays (40b and 42b), each of which makes an angle of approximately the same magnitude but opposite sign with the vertical (54).

4. Structure according to Claim 2 or 3, characterized in that the downward-pointing steps (30e) of the outward-pointing flat lens (30a) enclose prismatic channels (31) together with upward-pointing steps (32a) of the same step interval as a flat lens (30b) underneath.

5. Structure according to Claim 4, characterized in that grooves (37) run at right angles to the channels (31), thin-walled, band-like strips (38) which fix the flat lenses (30a and 30b) to one another in the direction of the channels (31) projecting into said grooves.

6. Structure according to any of Claims 2 to 4, characterized in that those boundary surfaces of the steps (e.g. 30e and 32a) of the superposed flat lenses (30a and 30b) through which rays pass consist of adjacent, parallel strip-like regions (46a and 47a, 46b and 47b) which make an obtuse angle with one another.

7. Structure according to any of Claims 2 to 4, characterized in that the flanks of the downward-pointing steps of the lower flat lens (30b) have strip-like regions (48a, 48b) which lie one on top of the other and make an obtuse angle with one another.

8. Structure according to any of Claims 4 to 7, characterized in that those boundary surfaces (46b, 47b) of each step of the upper flat lens (30a) through which rays pass and those boundary surfaces (46a, 47a) of each upward-pointing step of the flat lens (30b) underneath through which rays pass enclose two triangular channels (46, 47), the larger (46) of which tapers towards the sun in the operating position and the smaller (47) of which widens towards the sun in the operating position.

9. Structure according to any of Claims 2 to 8, characterized in that the downward-pointing side of the transparent roof consists of facets (51) having edges parallel at right angles to the perpendicular plane of incidence, those surfaces of the facets (51) through which rays pass being inclined relative to the horizontal so that a vertical section through the facets (51) at right angles to the vertical plane of incidence is equivalent to a section through a Fresnel lens, and that a section of the facets exhibits a periodic gradation parallel to the plane of incidence.

10. Structure according to any of Claims 2 to 4, characterized in that the flank-forming surfaces (45a, 45b, 48a, 48b) of the roof-forming flat lenses, through which rays in an emergence angle interval (40a, 41) do not pass in the operating position, are mirrored, and that these mirrored surfaces (45a, 45b, 48a, 48b) make with the vertical (54) an angle such that rays (41c) incident on these flanks are reflected in a direction such that they emerge within the emergence interval formed by only refracted sun rays (40b and 42b).

11. Structure according to any of the preceding Claims, characterized in that the first group of downward-pointing steps (60) of a roof-forming flat lens has a large interval, and that those boundary surfaces of this step (60) through which rays pass carry secondary steps which are at right angles to the steps (60) and have a smaller interval with the changing angles of a Fresnel lens.

12. Structure according to any of the preceding Claims, characterized in that the transparent roof (3) contains a flat lens whose prism-forming steps (71) symmetrical to a crest (70) parallel to the plane of incidence run along curved paths, the prism angles becoming larger over the length of the steps with increasing distance from the crest (70), and furthermore that the prism angles coordinated with each distance from the crest (70) and the angles between the respective tangents at the step (71) and at the crest (70) are chosen so that all incident sun rays are refracted towards the focal line.

13. Structure according to any of the preceding Claims, characterized in that a secondary lens (12, 80, 103, 104) is arranged between the transparent roof (3) and the photocells (4, 81, 94), the optical geometry of which secondary lens deflects ray pencils onto the photocells (4, 81, 94) within the limits of a predetermined zenith angle interval, said ray pencils generating, as a function of the respective zenith angle, focal lines (121, 124, 127) at different distances from the transparent roof (3).

14. Structure according to Claim 13, characterized in that the photocells (4, 81, 94, 112a) are optically connected to the secondary lens without any spacing.

15. Structure according to Claim 13 or 14, characterized in that the geometry of the secondary lens (12, 80, 103, 104) deflects the sun rays refracted to give ray pencils (122, 123, 126), provided that said sun rays strike the secondary lens (12, 80, 103, 104) in a manner laterally displaced relative to the photocells (81, 94, 102), so that these rays pencils (122, 123, 126) are always incident on the photocells (81, 94, 102) within a predetermined interval (89) of the lateral emergence.

16. Structure according to any of Claims 13 to 15, characterized in that the shape of the incidence surface (83, 83a) with the secondary lens (80) is such that the focal lines are within the secondary lens (80) so that they migrate through the photocells (81) at a small zenith angle.

17. Structure according to any of Claims 13 to 16, characterized in that the cross-section of the secondary lens (80) forms a trapezium whose lower side faces the photocells (81, 94, 102) and which has symmetrically divergent sides (84) and an upper side (83) which is formed from three regions and consists of regions (83a), which resemble sections of a longitudinally cut upper half of an ellipse with a horizontal long axis, and a middle region (88, 90, 104) which produces divergent refraction of obliquely incident rays (87b).

18. Structure according to Claim 13, characterized in that the lower side of the secondary lens (80) faces the photocells (81, 94, 102) and that the cross-section of the secondary lens has wall regions which are symmetrical with respect to the vertical and are formed from the sides of trapezoids lying one on top of the other, and that the upper side (90) resembles an arc of a circle.

19. Structure according to Claim 13, characterized in that a cylindrical lens (104) whose outer regions (103a, 103b) produce convergent refraction is held a predetermined distance above the photocells (102) by mirrored wall regions (101).

20. Structure of a collector platform according to Claim 1, characterized in that the distance between photocells and transparent roof is adjustable.

21. Structure as claimed in any of the preceding Claims, characterized in that an element of an assembly which consists of a photocell (112a) having a centre line (119) and a secondary lens (116) or a part of such a secondary lens is arranged displaceably relative to another such element, the distance (117a) between the centre line (119) and the line of symmetry of the secondary lens (116) being variable, and that, depending on the drift of the zone of highest radiant intensity from the photocell (112a), means effect a relative shift which brings the photocell (112a) and the zone of highest radiant intensity into coincidence again.

22. Structure according to any of the preceding Claims, characterized in that several layers (35) of an extremely thin peelable film (36) are arranged on the transparent roof (3, 30, 50).

## Revendications

1. Structure d'une plateforme collectrice pour des centrales énergétiques solaires, susceptibles de pivoter autour d'un axe vertical (D), plateforme flottant sur une couche de liquide (2) et présentant un toit (3, 114) transparent, s'étendant à une certaine distance au-dessus de la couche de liquide et réfractant, en direction du bas, les rayons solaires arrivant, en les concentrant sur des photopiles (4) se trouvant au-dessous, disposées dans des auges (10) s'étendant parallèlement les unes aux autres, caractérisée en ce que les photopiles (4) sont placées en liaison de conductibilité thermique vis-à-vis des auges (10) et en ce que les auges (10) sont réalisées de manière que les pertes thermiques des photopiles (4) sont introduites pour la majeure partie dans la couche de liquide (2), en passant à travers une zone des auges (10) qui est située au-dessous de la face supérieure de la couche de liquide (2).

2. Structure selon la revendication 1, caractérisée en ce que la couche, tournée vers l'extérieur, du toit transparent (3) constitue une lentille plate (30a), s'étendant horizontalement, avec une première surface limite (35, 50) lisse tournée vers l'extérieur qui présente, sur sa face tournée vers le bas, un groupe de deuxièmes surfaces limites, subdivisées en étagements (30e), qui, en position de fonctionnement, s'étendent transversalement par rapport aux rayons solaires, les étagements (30e) faisant avec la première surface limite (35, 50) un angle tel que, le cas échéant en coopération avec une autre lentille plate (30b) dotée d'étagements (32a), le cas échéant avec des étagements (34, 51, 64, 65, 66) s'étendant à angle droit par rapport aux étagements cités, un rayon solaire (40a), ayant un angle au zénith supérieur à 60° est cassé pour donner un rayon de sortie (40b) qui constitue, par rapport à la direction opposée au soleil vis-à-vis de la verticale, un angle inférieur à 30° tandis qu'un rayon solaire (42a), ayant un angle au zénith inférieur à 20 degrés, est cassé pour donner un rayon de sortie (42b) tourné dans la direction du soleil et formant avec la verticale (54) un angle inférieur à 30°, et en ce que les rayons sortant du toit transparent (3) sont concentrés sur une ligne focale (121, 124, 127) s'étendant parallèlement aux rayons solaires.

3. Structure selon la revendication 2, caractérisée en ce que les rayons (40a et 42a), délimitant un intervalle angulaire de zénith, sont cassés pour donner leurs rayons de sortie (40b, 42b) afférents, faisant avec la verticale (54) respectivement, un angle ayant à peu près la même valeur mais étant cependant de signe opposé.

4. Structure selon la revendication 2 ou 3, caractérisée en ce que les étagements (30e), tournés vers le bas, de la lentille plate (30a) tournée vers l'extérieur enclosent, conjointement avec les étagements (32a), tournés vers le haut et appartenant à la même division d'étagements, d'une lentille plate (30b) installée en position sous-jacente, des canaux (31) prismatiques.

5. Structure selon la revendication 4, caractérisée en ce que, perpendiculairement aux canaux (31), courent des cannelures (30) dans lesquelles pénètrent des bandes (38) en forme de ruban, à parois minces, qui assurent la fixation des lentilles plates (30a et 30b) les unes par rapport aux autres dans la direction des canaux (31).

6. Structure selon l'une des revendications 2 à 4, caractérisée en ce que les surfaces limites, traversées par le rayonnement, des étagements (par exemple 30e et 32a) des lentilles plates (30a et 30b) placées l'une sur l'autre sont constituées de zones (46a et 47a, 46b et 47b) en forme de bandes, s'étendant les unes à côté des autres, parallèlement les unes aux autres et faisant entre elles un angle obtus.

7. Structure selon des revendications 2 à 4, caractérisée en ce que les flans des étagements, tournés vers le bas, de la lentille plate (30b) en position sous-jacente présentent des zones (48a, 48b) en forme de bandes placées les unes au-dessus des autres, faisant entre elles des angles obtus.

8. Structure selon l'une des revendications 4 à 7, caractérisée en ce que les surfaces limites (46b, 47b), traversées par le rayonnement, de chaque étagement de la lentille plate (30a) située en position supérieure et les surfaces limites (46a, 47a), traversées par le rayonnement, de chaque étagement, tourné vers le haut, de la lentille plate (30b) sous-jacente enclosent deux canaux (46, 47) triangulaires, dont le plus grand (46) va en s'effilant en position de fonctionnement, dans la direction allant vers le soleil, et dont le plus petit (47) va en s'agrandissant en position de fonctionnement, dans la direction allant vers le soleil.

9. Structure selon l'une des revendications 2 à 8, caractérisée en ce que la face, tournée vers le bas, du toit transparent est constituée de facettes (51) ayant des arêtes s'étendant parallèlement et à angle droit vis-à-vis du plan vertical d'arrivée du rayonnement, les surfaces, traversées par le rayonnement, des facettes (51) étant inclinées par rapport à l'horizontale, de manière à ce qu'une coupe verticale, faite dans les facettes (51), à angle droit par rapport au plan d'arrivée de rayonnement s'étendant verticalement, équivale à une coupe dans une lentille de Fresnel et qu'une coupe des facettes, faite parallèlement au plan d'entrée de rayonnement, présente un étagement périodique.

10. Structure selon les revendications 2 à 4, caractérisée en ce que les surfaces (45a, 45b, 48a, 48), constituant les flancs, des lentilles plates constituant le toit, qui sont traversées en fonctionnement par des rayons qui n'arrivent pas dans les limites d'un intervalle angulaire de sortie (40, 41b) sont rendues réfléchissantes, et en ce que ces surfaces (45a, 45b, 48a, 48b) rendues réfléchissantes font, avec la verticale (54), un angle tel que des rayons (41c), arrivant sur ces flans, sont réfléchis dans une direction telle qu'ils sortent dans les limites d'un intervalle de sortie constitué par les seuls rayons solaires (40b et 42b) ayant subi une cassure de réfraction.

11. Structure selon l'une des revendications 2 à 10 précédentes, caractérisée en que le premier groupe d'étagement (60), tourné vers le bas, d'une lentille plate constituant le toit présente une subdivision grossière et en ce que les surfaces limites, traversées par le rayonnement, de cet étagement (60) portent des étagements secondaires (64, 65, 66), s'étendant à angle droit par rapport aux étagements (60) et présentant une subdivision plus fine avec une variation des angles telle que pour une lentille de Fresnel.

12. Structure selon l'une des revendications précédentes, caractérisée en ce que le toit transparent (3) contient une lentille plate dont les étagements (61) constituant des prismes s'étendent symétriquement par rapport à une ligne de sommet (70) située parallèlement par rapport au plan d'arrivée de rayonnement, sur des trajectoires courbes, les angles de prismes allant en augmentant sur la longueur des étagements, lorsque l'espacement vis-à-vis de la ligne de sommet (70) augmente, en outre entre ce que les angles de prisme, associés à chaque espacement vis-à-vis de la ligne de sommet (70), et les angles, faits entre les tangentes respectives sur l'étagement (71) et la ligne de sommet (70), sont choisis tel que tous les rayons solaires arrivant sont réfractés en direction d'une ligne focale.

13. Structure selon l'une des revendications précédentes caractérisée en ce qu'entre le toit transparent (3) et les photopiles (4, 81, 94) est disposée une lentille secondaire (12, 80, 103, 104), dont la géométrie optique dévie sur les photopiles (4, 81, 94) des faisceaux de rayon générés, se trouvant dans les limites d'un intervalle angulaire au zénith prédéterminé, en fonction de l'angle au zénith respectif, pour arriver sur des lignes focales (121, 214, 127) situées à un espacement différent vis-à-vis du toit transparent (3) .

14. Structure selon la revendication 13, caractérisée en ce que les photopiles (4, 81, 94, 112a) sont reliées sans espacement optique à la lentille secondaire (12, 80).

15. Structure selon la revendication 13 ou 14, caractérisée en ce que la géométrie de la lentille secondaire (12, 80, 103, 104), qui dévie les rayons solaires ayant été réfractés pour donner des faisceaux de rayon (122, 123, 126), dans la mesure où ceux-ci touchent la lentille secondaire (12, 80, 103, 104) en étant décalés latéralement par rapport aux photopiles (81, 84, 102), de manière que ces faisceaux de rayons (122, 123, 216) touchent toujours les photopiles (81, 94, 102) dans les limites d'un intervalle (89) prédéterminé de l'excursion latérale.

16. Structure selon des revendications 13 à 15, caractérisée en ce que la forme de la surface d'entrée (83, 83a) de la lentille secondaire (80) est telle que les lignes focales courent à l'intérieur de la lentille secondaire (80) de manière qu'elles cheminent en passant par les photopiles (81) lorsque l'angle au zénith est petit.

17. Structure selon l'une des revendications 13 à 16, caractérisée en ce que la section transversale de la lentille secondaire (80) constitue un trapèze, dont la face inférieure est tournée vers les photopiles (81, 94, 102) et qui présente des faces (84) allant en divergeant symétriquement et une face supérieure (83) constituée par trois zones, qui sont constituées par des zones (83a), analogues à des parties d'une moitié supérieure, coupée longitudinalement, d'une ellipse ayant un grand axe courant horizontalement, et par une zone médiane (88, 90, 104) provoquant une réfraction divergeante des rayons (87b) arrivant obliquement.

18. Structure selon la revendication 13, caractérisée en ce que la face inférieure de la lentille secondaire (80) est tournée vers les photopiles (81, 94, 102), et en ce que la section transversale de la lentille secondaire présente des zones de paroi s'étendant symétriquement par rapport à la verticale et constituées par les côtés de trapézoïdes placés les uns au dessus des autres, et en ce que la face supérieure (90) est analogue à un tronçon d'arc de cercle.

19. Structure selon la revendication 13, caractérisée en ce que qu'une lentille cylindrique (104), dont les zones extérieures (103a, 103b) provoquent une réfraction convergente, est maintenue à une distance prédéterminée au-dessus des photopiles (102), au moyen de zones de parois (101) rendues réfléchissantes.

20. Structure d'une plateforme collectrice selon la revendication 1, caractérisée en ce que l'espacement entre les photopiles et le toit transparent est réglable.

21. Structure selon l'une des revendications précédentes caractérisée en ce qu'un élément d'un groupe de construction, constitué d'une photopile (112a) ayant une ligne médiane (119) et une lentille secondaire (116) ou une partie d'une telle lentille secondaire, est disposé de façon mobile par rapport à un autre élément de ce type, l'espacement (117a) entre la ligne médiane (119) et la ligne de symétrie de lentille secondaire (116) étant modifiable, et en ce que des moyens provoquent, en fonction de l'excursion de la zone de l'intensité maximale d'irradiation de la photopile (112a), un déplacement relatif qui refait coïncider la photopile (112a) et la zone de l'intensité maximale d'irradiation.

22. Structure selon l'une des revendications précédentes caractérisée en ce que plusieurs couches (35) d'une feuille (36) extrêmement mince et enlevable sont disposées sur le toit transparent (3, 30, 50).
